# EUROPEAN PATENT APPLICATION

(11) **EP 1 624 355 A2**
(43) Date of publication of application: **08.02.2006**
(21) Application number: 05253944.2
(22) Date of filing: 24.06.2005
(51) Int. Cl.: G05D 7/06

(54) **Fluid flow control device**

(30) Priority: 01.07.2004 US 883197
(71) Applicant: THE BOC GROUP, INC., New Providence, NJ 07974-2082 (US)
(72) Inventor: Pozniak, Peter Martin, San Jose, California 95129 (US)
(74) Representative: Booth, Andrew Steven

(57) **Abstract**

A fluid flow control device (5) includes an inlet (120) for passing a fluid into the device, and an outlet (125) for passing the fluid from the device. The device also may include a pressure regulating portion (15,20) configured to receive the fluid and to deliver the fluid at a controlled pressure. The device further may include a flow control valving portion (35) configured to receive the fluid delivered by the pressure regulating portion and to deliver the fluid at a controlled flow rate. In addition, the device may include a flow meter (25) configured to measure the flow rate of the fluid, and a controller (115) that controls at least the flow control valving portion according at least the flow measured by the flow meter. In some examples, the device may be used to pass fluid to a semiconductor processing tool and/or to blend multiple fluids.

## Description

The present invention relates to a device for controlling the flow of fluids, such as a flow rate control device configured to deliver fluids in semiconductor applications.

Devices presently available for controlling the flow of fluids are as numerous and varied as the different applications requiring such control. In some instances, fluid flow control can be a challenge. For example, in some applications, variations in the supply of fluid, or in the output conditions for that fluid, make it difficult to control the flow rate of the fluid precisely and repeatably. Such variations also make it difficult to adjust to fluctuations in fluid pressure and flow rate.

Due to these difficulties, some existing fluid flow control devices are not capable of both precise and repeatable fluid delivery. In fact, some existing fluid flow control devices have only a limited ability to compensate for variations upstream or downstream, and are not well suited to adjusting to fluctuating fluid conditions within the device. The limited capability of some current designs may be attributed to a number of factors. For example, the valves used in some devices may be sufficient for controlling the flow rate of the fluid but not particularly suitable for turning the flow on and off. Similarly, the components used in some devices may be capable of measuring the flow or pressure of fluid, but not very accurate due to fluctuations in fluid flow or pressure.

Some existing arrangements do not respond rapidly to changing flow control conditions. In some instances, a relatively appreciable delay exists between a change in flow rate and the detection of that change. As a result, a feedback control loop may only be as responsive as the flow meter or other measurement device used.

In at least its preferred embodiment, the present invention relates to a fluid flow control device that may at least partially avoid some or all of the aforementioned shortcomings of existing devices.

In a first aspect, the present invention provides a fluid flow control device comprising a fluid inlet, a fluid outlet, pressure regulating means for receiving the fluid and outputting the fluid at a controlled pressure, flow control valving means for receiving the fluid output from the pressure regulating means and outputting the fluid at a controlled flow rate, a flow meter for measuring the flow rate of the fluid, and control means for controlling at least the flow control valving means according to at least the flow rate measured by the flow meter.

In accordance with a preferred embodiment of the present invention, a fluid flow control device may include an inlet for passing fluid into the device, and an outlet for passing fluid from the device. The fluid flow control device may also include a pressure regulating portion configured to receive the fluid and to deliver the fluid at a controlled pressure. The device may include a flow control valving portion configured to receive the fluid delivered by the pressure regulating portion and to deliver the fluid at a controlled flow rate. In addition, the device may include a flow meter configured to measure the flow rate of the fluid, and a controller that controls at least the flow control valving portion according to at least the flow measured by the flow meter.

The pressure regulating portion of the device may include a pressure regulator and a regulator pilot valve for pneumatically controlling the pressure regulator. The fluid flow control device may also include a pressure meter configured to measure the pressure of the fluid. The controller may control the regulator pilot valve, and may also be configured to control the regulator pilot valve according to at least the pressure measured by the pressure meter.

The flow control valving portion may include a flow control valve and a stepper motor for controlling the flow control valve. For example, the controller may control the stepper motor, and the flow meter may measure the flow rate of fluid upstream from the flow control valve.

The fluid flow control device may include means for inputting a desired fluid flow rate. The controller may control the flow control valve according to at least the desired fluid flow rate and the measured flow rate. The fluid flow control device may also include a display for displaying the input desired flow rate, and measured flow rate.

The fluid flow control device may also include an outflow valve portion. This portion may be configured to apply suction via the fluid outlet, and may include an outflow valve (for example, a suck back valve) and a pilot valve for pneumatically controlling the outflow valve. In some examples, the controller may control the outflow valving portion such that the outflow valving portion is changed from a fluid shut off position to a fluid flow position when the pressure regulating portion and the flow control valving portion are set for desired flow conditions.

The fluid flow control device may also include an inflow port for purge media and a purge media valving portion configured to control the flow of purge media through at least a portion of the device including at least the outlet. The purge media valving portion may include a purge media valve and a pilot valve pneumatically controlling the purge media valve.

The fluid flow control device may also include a check valve configured to limit the flow of fluid from the device via the inlet. The device may also include an inflow port for a pressurized substance. The pressure regulating portion may be configured to be pneumatically controlled by using the pressurized substance.

The fluid flow control device may further include a pressure meter configured to measure pressure of the fluid. The controller may control the regulator pilot valve according to at least the pressure measured by the pressure meter.

A further aspect relates to a system for use in semiconductor processing. The system may include at least one fluid flow control device as aforementioned, and at least one semiconductor processing tool. The semiconductor processing tool may receive fluid from the at least one fluid flow control device.

Yet another aspect relates to a system for use in the flow control of multiple fluids, including a first fluid flow control device and a second fluid flow control device each as aforementioned. The devices may be in communication with each other. The first fluid flow control device may include a male connector and the second fluid flow control device may include a female connector configured to be coupled to the male connector.

The system may also include a bus module configured to enable the system to be in communication with a controlling unit. The bus module may include a female connector configured to be coupled to a male connector of the second fluid flow control device. In addition, each of the first and second fluid flow control devices may also include a means for inputting a desired fluid flow rate. Each of the devices may further include a display displaying the input desired flow rate and the measured flow rate.

One further aspect relates to a system for use in blending multiple fluids. The system may include a first fluid flow control device, a second fluid flow control device, each as aforementioned, and a mixer, wherein the outlet of each of the first and second flow devices is flow coupled to the mixer. For example, the system may be configured so as to control the first and second fluid flow control devices so as to provide the mixer with multiple fluid flows, wherein each fluid flow may have a controlled flow rate and a controlled flow rate duration.

Aside from the structural arrangements set forth above, the invention could also include a number of other arrangements such as those explained hereinafter. It is to be understood that both the foregoing description and the following description are exemplary only.

Preferred features of the present invention will now be described, by way of example only, with reference to the accompanying drawings, in which:
Fig. 1 is a side cut-away view of an embodiment of a fluid flow control device;
Fig. 2 is a top cut-away view of the device of Fig. 1;
Fig. 3 is a side view of an exemplary bus module for use with the device of Fig. 1;
Fig. 4 is a side view of an embodiment of a system including a plurality of fluid flow control devices and a bus module;
Fig. 5 is a schematic view of the fluid flow control device of Fig. 1;
Fig. 6 is a schematic view of an alternative embodiment of a system that includes fluid flow control devices being flow coupled to a component; and
Fig. 7 is a schematic view of an exemplary controller for the device of Fig. 1, the controller being in communication with a number of pilot valves, a regulator pilot valve, a stepper motor, a flow meter, and a pressure meter.

Reference will now be made in detail to several exemplary embodiments of the present disclosure. Wherever possible, the same reference numbers will be used throughout the drawings to refer to the same or like parts.

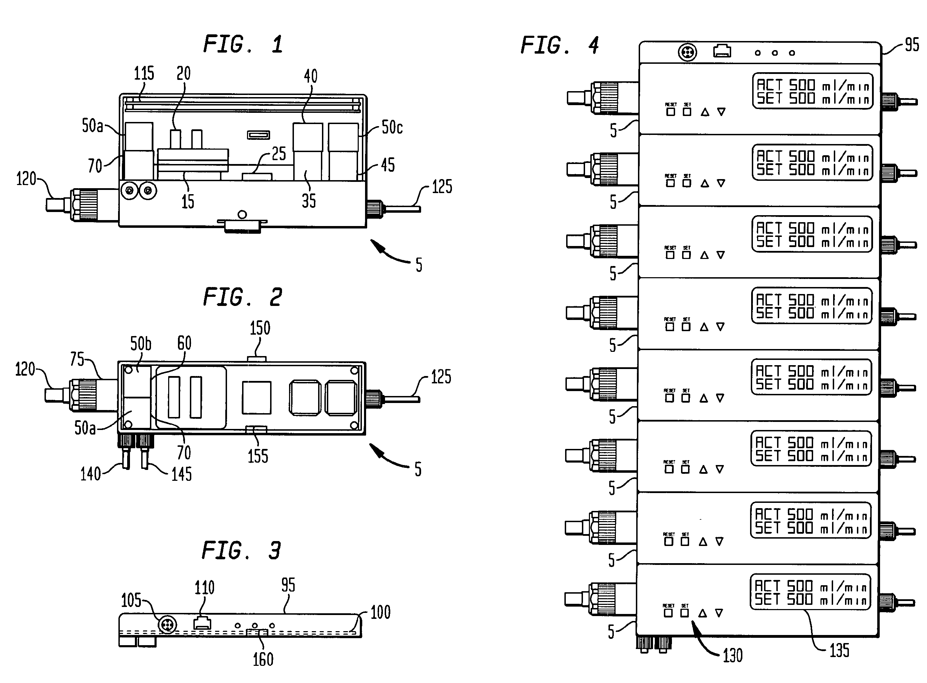

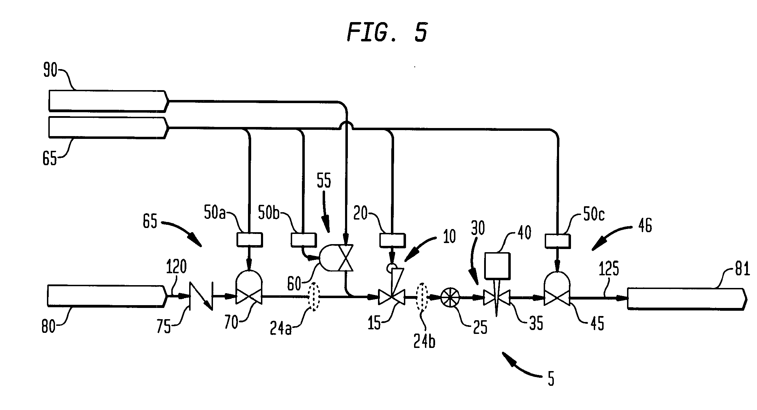

Figs. 1 and 2 show an embodiment of a fluid flow control device 5 including an inlet 120 and an outlet 125. The inlet 120 may be fluidly connected to a fluid source 80 as shown in Fig. 5, and may be configured to allow a fluid to enter the fluid flow control device 5. The fluid to be controlled by the fluid flow control device 5 may be any fluid having properties suitable for permitting flow of the fluid to be controlled. The fluid may be in a liquid, slurry, or gaseous form, and may have a relatively low viscosity and relatively low reactivity. Examples of some fluids include, but are not limited to, water, molten silicon, platinum, copper, or any other fluid, such as any other fluid used in the art of semiconductor manufacturing.

The outlet 125 may be fluidly connected to a component 81 as shown in Fig. 5, and may be configured to allow fluid to exit the fluid flow control device 5. The component 81 may be a processing tool, or any other type of component configured to receive a fluid. The type of component 81 connected to the outlet 125 may depend on the application in which the fluid flow control device 5 is used. One exemplary component 81 is a semiconductor processing tool such as, for example, a spray-on tool, a spin-on tool, or a tool that dispenses fluid to a wafer processing chamber, vacuum chamber, or other environment known in the art.

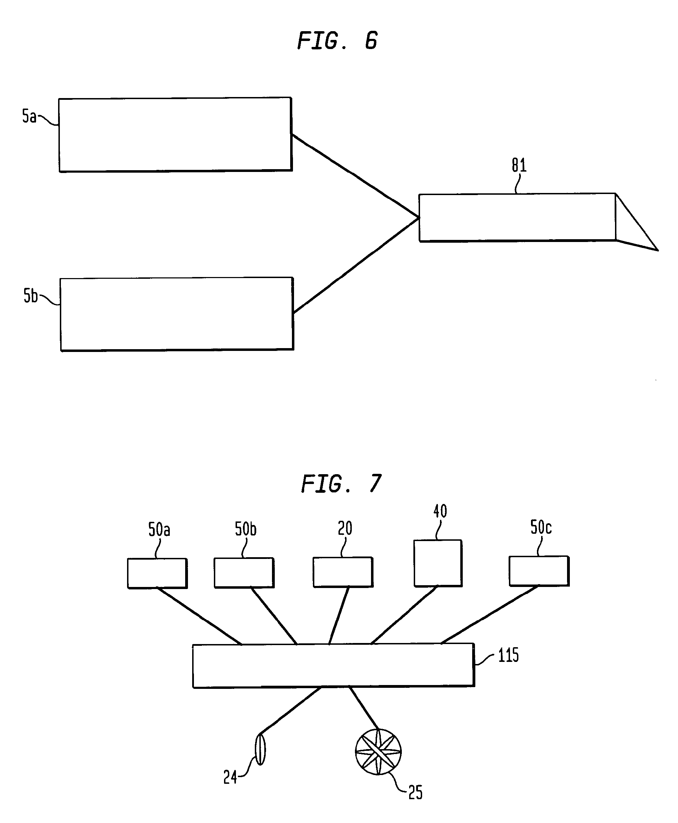

The fluid flow control device 5 may further include a controller 115 (shown in Figs. 1 and 7), a pressure regulating portion 10, a flow meter 25, and a flow control valving portion 30. The pressure regulating portion 10, flow meter 25, and flow control valving portion 30 are schematically illustrated in Fig. 5. The pressure regulating portion 10 may include a pressure regulator 15 and a regulator pilot valve 20, and may be configured to receive a flow of fluid and deliver the fluid at a controlled pressure. The pressure regulator 15 may be, for example, a dome loaded pressure regulator or any other actuated pressure regulator known in the art. The pressure regulator 15 may be used to manage the pressure of a fluid downstream of the pressure regulating portion 10, and may be responsive to the downstream pressure of the fluid through a feedback loop. The pressure regulator 15 may be a valve regulator that is configured to be pneumatically controlled.

As shown in Fig. 5, the regulator pilot valve 20 may be flow coupled to a pressurized substance source 65. The regulator pilot valve 20 may control a pressurized flow of a pressurized substance from the source 65 to the pressure regulator 15 so as to pneumatically actuate the regulator 15, and cause the regulator 15 to establish a particular fluid pressure downstream from the regulator 15. The regulator pilot valve 20 may receive an electric signal from the controller 115 and, according to that signal, cause the pressure regulator 15 to be actuated a corresponding amount to supply a particular pressure of the pressurized substance and thereby actuate the pressure regulator 15. Thus, the pilot valve 20 may accept an electric signal from the controller 115 and allow a regulated pressure of the pressurized substance to act on the pressure regulator 10 based on the electric signal. The pressure regulator 15 may respond to the pressurized substance by opening its orifice or other passage a corresponding amount, thereby regulating the pressure of the fluid downstream of the pressure regulating portion 10. Thus, the fluid downstream of the pressure regulator 15 may have a managed pressure.

The pressurized substance may include, but is not limited to, nitrogen, oxygen, air, or any other gas known in the art to be suitable for operating pneumatic valves or other fluid flow control components.

Optionally, the fluid flow control device 5 may further include one or more pressure meters 24 as shown in Fig. 5. A pressure meter 24a may be located upstream of the pressure regulating portion 10. In such an example, the pressure meter 24a may measure the pressure of the fluid before it enters the pressure regulator 15, and may send a measurement signal to the controller 115 so as to enable the controller 115 to control the regulator pilot valve 20 according to that sensed pressure. This may enable the pressure regulator 15 to be adjusted for fluctuations in fluid pressure occurring upstream.

A pressure meter 24b may also (or alternatively) be located downstream of the pressure regulating portion 10. The downstream pressure meter 24b may provide feedback to the controller 115 so as to enable the controller 115 to determine how well the pressure of the fluid is being controlled by the pressure regulator 15. Similar to the upstream pressure meter 24a, the pressure measured by the downstream pressure meter 24b may be used to control the pressure regulator 15.

As shown in Figs. 1 and 5, the flow control valving portion 30 of the fluid flow control device 5 may include a flow control valve 35 controlled by a motor 40. The flow control valve 35 may receive fluid at a pressure controlled by the regulating portion 10, and may regulate the flow rate of the fluid as it passes from the flow control device 5. In some examples, the motor 40 controlling the flow control valve 35 receives an electric signal from the controller 115 and mechanically actuates the valve 35 to control the fluid flow rate based on that signal. The motor 40 could be a stepper motor, servo motor, or any other type of electric motor (e.g., precision electric motor) known in the art. Likewise, the flow control valve 35 could be any form of motor driven flow control valve commonly known in the art.

As mentioned above, and illustrated in Figs. 1, 2 and 5, the fluid flow control device 5 may also include a flow meter 25. After the fluid exits the pressure regulator 15 at a managed pressure, the flow meter 25 may measure the flow rate of fluid upstream of the flow control valve 35. (Alternatively, the flow meter 25 may be located downstream of the flow control valve 35.) The flow meter 25 may transmit a flow rate measurement signal to the controller 115.

The controller 115 may control the pressure regulating portion 10, and the flow control valving portion 30, according to the measured flow rate.

The flow meter 25 may be an ultrasonic flow meter capable of detecting the velocity of a flow in a calibrated tube through doppler shift or time of flight type measurements. Alternatively, the flow meter 25 may be a pressure differential type, a coriolis type, a vortex shedding type, a hot wire type, or any other type of flow meter known in the art.

In some examples, the flow meter 25 measures fluid flow downstream of the pressure regulator 15, and sends a measurement signal to the controller 115. The controller 115 receives the measurement signal in addition to possibly also receiving additional signals, such as a signal relating to a desired flow rate for the fluid. The controller 115 then sends corresponding pressure and flow signals to the regulator pilot valve 20 and motor 40 respectively. In this way, the flow meter 25 communicates with the controller 115 to form a continuous feedback loop to control other components of the fluid flow control device 5. Fig. 7 graphically illustrates an example of communication links between components that might be associated with the feedback loop.

In other examples (not shown), the feedback loop may include only the flow meter 25, motor 40, and controller 115.

In a further example, the feedback loop may include both the flow meter 25 and the pressure meter 24a and/or 24b sending flow and pressure measurements respectively to the controller 115. In such an example, the controller 115 may determine pressure and flow rate command signals according to that input as well as other input (e.g., the desired flow rate) and then send corresponding pressure and flow rate signals to the regulator pilot valve 20 and stepper motor 40 respectively.

In still another example (not shown), the fluid flow control device 5 may further include a second pressure regulating portion, like pressure regulating portion 10, but located downstream of the flow control valving portion 30. This second pressure regulating portion may serve as a back pressure regulator, isolating any variation in downstream pressure conditions from the flow and pressure meters 25, 24a and/or 246.

The fluid flow control device 5 may further include an outflow valving portion 46, including an outflow valve 45 optionally controlled by a pilot valve 50c. The outflow valve 45 may be located near the outlet 125 of the fluid flow control device 5. In some examples, the outflow valve 45 may be a suck back valve configured to apply suction via the outlet 125 that may draw at least some fluid into the device 5 via the outlet 125. For some exemplary arrangements, the suction force may limit the formation of fluid droplets, residue, or other fluid-related issues associated with the component 81. For example, when the component 81 is a semiconductor processing tool having a dispensing nozzle, sprayer, or some other form of fluid dispenser, the suck back valve may limit the formation of fluid droplets or residue associated with the fluid dispenser of the component. The suck back valve 45 may be actuated when a downstream process (e.g., a component 81 in the form of a semiconductor processing tool 81) stops demanding fluid. When actuated, the suck back valve 45 may draw at least some fluid back through the outlet 125 of the fluid flow control device 5. As a result, the suck back valve 45 may limit flow related issues from arising while fluid flow is stopped. For example, when the component has a fluid spray nozzle, a suck back valve may ensure a clean spray of fluid from the spray nozzle when fluid flow is resumed.

In other examples, the outflow valve 45 may be a shut off valve or other type of two-way valve commonly known in the art of fluid control, and the valve 45 may be configured to prevent any fluid from flowing back into the device 5 once it has passed through the outlet 125, or after the flow of fluid has stopped. The outflow valve 45 may also be configured to protect the components of the fluid flow control device 5 from damage caused by a downstream vacuum or other abnormal hydraulic condition.

In some examples, the outflow valve 45 may be set to open (e.g., via controller 115) only when the pressure regulating portion 10 and flow control valving portion 35 are controlled to place them in a position permitting a desired flow and a downstream process (e.g., component 81) demands the flow. The outflow valve 45 may be set to remain closed in all other conditions, and may also be set to close as soon as the downstream processing tool 81 stops demanding fluid. In other examples, the outflow valve 45 may allow the pressure regulator 15 and the flow control valve 35 to maintain consistent positions during start-up and stoppage of the fluid flow, and thus possibly reduce flow variation.

As shown in Fig. 5, the pilot valve 50c of the outflow valving portion 46 may be coupled to the pressurized substance source 65, and may be configured to control a flow of the pressurized substance from the source 65 to the outflow valve 45. The pilot valve 50c may be an electric solenoid valve, or any other type of open/close pneumatic valve known in the art. Alternatively, a stepper motor, servo motor, or any other type of electric motor (e.g., precision electric motor) known in the art may be used to actuate the outflow valve 45, rather than the pilot valve 50c. In examples where the outflow valve 45 is a suck back valve, the pilot valve 50c, or alternatively one of the electric motors described above, may be used to control the amount and rate of suction that causes fluid to be drawn back into the device 5 via the outlet 125.

To actuate the outflow valve 45, the controller 115 may send an electric signal to the pilot valve 50c, causing the valve 50c to allow the pressurized substance to pneumatically actuate the outflow valve 45. In this way, the outflow valve 45 may be pneumatically actuated to either shut off the flow of fluid, permit fluid to flow out of the outlet 125, or draw fluid back into the device 5.

As shown in Figs. 2 and 5, the fluid flow control device 5 may further include a check valve 75. The check valve may be located at or near the inlet 120 of the fluid flow control device 5, and may permit fluid to flow into the device 5 from the fluid source 80 while preventing fluid flow from the device 5 via inlet 120. The check valve 75 may be any type of one-way flow valve known in the art.

The fluid flow control device 5 may further include a purge media valving portion 55 and a shut off valving portion 65. The purge media valving portion 55 may include a purge media valve 60 controlled by a pilot valve 50b. Similarly, the shut off valving portion 65 may include a shut off valve 70 controlled by a pilot valve 50a. The purge media and shut off valves 60, 70 may be shut off valves or other types of two-way valves commonly known in the art of fluid control.

The purge media valve 60 may be fluidly coupled to a purge media source 90 and may be configured to permit a purge media to flow into the fluid flow control device 5 and possibly also pass through the outlet 125 and into tool 81. The purge media may be a relatively pure purging media (e.g., cleaning agent) known in the art of fluid control such as, but not limited to, de-ionized water, distilled water, or diluted bleach. As shown in Fig. 5, the purge media valve 60 may be located upstream of the pressure regulating portion 10 in order to maximize the travel of the purge media through the fluid flow control device 5. Thus, the purge media valving portion 55 may enable the purge media to flow through at least a portion of the device 5 including at least the outlet 125. This flow of purge media may be desired before or after a fluid is delivered to a processing tool 81, or before a new fluid is introduced into the device 5.

The shut off valve 70 may be located upstream or downstream of the purge media valve 60 and may be configured to start and stop the flow of fluid to other components of the fluid flow control device 5. The purge media valve 60 and the shut off valve 70 may be pneumatically controlled and actuated by pilot valves 50b and 50a. The pilot valves 50b and 50a are coupled to the pressurized substance source 65 and are configured to control the flow of the pressurized substance from the source 65 to the purge media and shut off valves 60 and 70, respectively. The pilot valves 50b and 50a may be electric solenoid valves, or other types of open/close pneumatic valves commonly known in the art. To actuate either of the valves 60, 70, the controller 115 may send an electric signal to the respective pilot valve 50b, 50c causing the valve 50b, 50c to allow the pressurized substance to pneumatically actuate the purge media valve 60 or the shut off valve 70.

As illustrated in Fig. 2, the fluid flow control device 5 may include an inflow port for purge media 140 and an inflow port for a pressurized substance 145. The purge media inflow port 140 may be configured to accept a flow of purge media from the purge media source 90, thus allowing the purge media to flow to the purge media valving portion 55 of the fluid flow control device 5. In some examples, the purge media source 90 may include, but may not be limited to, a fluid tank, a sump, a fluid header, or any other type of purge media source container known in the art.

The pressurized substance inflow port 145 may be configured to accept a flow of the pressurized substance from the pressurized substance source 65. The pressurized substance source 65, may include, but may not be limited to, a high pressure gas tank, a pressurized gas header, a pressurized gas rail, or any other type of pressurized substance supply source container known in the art. The inflow port 145 may enable the pressurized substance to flow to any of the pilot valves 50a, 50b, 50c used in the device 5, as well as the regulator pilot valve 20.

As shown in Fig. 4, in an embodiment of the present invention, a number of fluid flow control devices 5 may be connected together so as to be in communication with each other. When connected in this way, the devices 5 may act together as a system for use in the flow control of multiple fluids. As shown in Fig. 2, each device may include a male and female connector 150, 155, respectively usable for connecting one device 5 with another device 5 so as to be in communication with each other. In addition to providing a physical connection between adjacent pairs of devices 5, the connectors 150 and 155 may also form an electric, pneumatic, fluid, and/or other connection between the devices 5.

The system shown in Fig. 4 may optionally include a bus module 95 configured to enable the system to be in communication with a controlling unit (not shown). For example, the controlling unit may be a personal computer, a server, a programmable logic controller or any other device known in the art to be used for the control of fluid control or other systems. To facilitate this communication, the bus module 95 may include an internet port 105 and an Ethernet port 110. The bus module 95 may also include, for example, a device port, a power port, or any other connection port or structure known in the art for connecting electric components

In some alternative examples, a number of fluid flow control devices 5 may be connected, so as to be in communication with each other, without the use of a bus module 95. For example, one or more components other than a bus module 95 may be used to enable a system of devices 5 to be in communication with a controlling unit.

As shown in Fig. 4, at least one bus module 95 may be used to control multiple fluid flow control devices 5, and may be coupled to a male connector 150 of one of the devices 5 using a female 160 connector (Fig. 3) configured for such a connection. When so connected, the bus module 95 may be in communication with all of the devices 5 in the system, and may be used to set desired flow rates. The bus module 95 may include a PC board 100 to facilitate this communication. In some examples, the PC board 100 may receive signals, pressure measurements, or flow measurements from any of the devices 5 in the system, or from a controlling unit or host. The PC board 100 may also process any of the signals or measurements received, and may transmit control signals to any of the devices 5 in the system. In this way, the bus module 95 may control the devices 5 in the system individually, or in conjunction with each other to supply a number of different fluids at different flow rates.

For example, in a semiconductor manufacturing process it may be desired to supply a number of fluids, each at different, and possibly varying, flow rates. To accomplish this dynamic blending of fluids, the bus module 95 may simultaneously control each device 5 so as to provide different flow rates for each supplied fluid. Each flow rate may be controlled to change with time. In such a scenario, each device 5 may supply a desired relative amount of fluid at a desired relative time in the semiconductor manufacturing process.

As shown in Fig. 4, each fluid flow control device 5 may further include a means for inputting a desired fluid flow rate 130, and a display 135. Fig. 4 illustrates a reset and a set button, as well as up and down buttons as exemplary means for inputting a desired fluid flow rate 130. However, it should be understood that many different forms of alternative input configurations are possible. For example, the means 130 may include, but may not be limited to, a digital control pad, a touch screen, a button panel, a keyboard or key pad, an internet connection, an Ethernet, devicenet or personal computer port, a wireless or infrared signal receiver, or any other commonly known means for inputting data to a device. In some examples, the tool 81 may supply information concerning a desired flow rate. In other examples, such as that shown in Fig. 4, a user may manually input a desired flow rate.

The controller 115 may be configured to control the flow control valving portion 30 and/or the pressure regulating portion 10 according to the desired flow rate inputted via the means for inputting a desired fluid flow rate 130. For example, the controller 115 may control the components of the device 5 so as to maintain the measured fluid flow rate (measured by flow meter 25) as close as possible to the inputted desired flow rate.

The display 135 may display the inputted desired flow rate, the measured flow rate (measured by flow meter 25), or any other information associated with either the controller 115, or the PC board 100, a host, a user, or any of the components of the fluid flow control device 5. The display 135 may be, but is not limited to, an LCD screen, a digital readout, a light array, a monitor, or any other type of display device used to output information. It is understood that the display 135 may be color or monochromatic, and that it may be of a different size, shape and/or configuration than that depicted in Fig. 4.

Fig. 6 schematically illustrates yet another embodiment of a system for use in semiconductor processing. Such an exemplary system may include at least one fluid flow control device (e.g., device 5a and device 5b) and at least one component 81 receiving fluid from the at least one device. It is understood that although Fig. 6 shows two devices 5a and 5b, any number of fluid flow control devices 5 could be used in such an embodiment to supply fluid to a single component 81 or to multiple components 81.

In some examples, the component 81 shown in Fig. 6 may be a semiconductor processing tool. Other possible examples may have a component other than a tool (e.g., other than a semiconductor processing tool). For example, the component 81 of Fig. 6 may be a mixer (e.g., static mixer) and outlets of the devices 5a and 5b may be flow coupled to the mixer to provide blending of multiple fluids. For example, each device 5a and 5b may be controlled so as to provide different flow rates for each supplied fluid. Each flow rate may be controlled to change with time. In such an example, each device 5a and 5b may supply a desired relative amount of fluid at a desired relative time.

It will be apparent to those skilled in the art that various modifications and variations can be made to the structure described herein. Thus, it should be understood that the invention is not limited to the subject matter discussed in the specification. Rather, the present invention is intended to cover modifications and variations.

## Claims

1. A fluid flow control device comprising a fluid inlet, a fluid outlet, pressure regulating means for receiving the fluid and outputting the fluid at a controlled pressure, flow control valving means for receiving the fluid output from the pressure regulating means and outputting the fluid at a controlled flow rate, a flow meter for measuring the flow rate of the fluid, and control means for controlling at least the flow control valving means according to at least the flow rate measured by the flow meter.

2. A device according to Claim 1, wherein the pressure regulating means comprises a pressure regulator and a regulator pilot valve for pneumatically controlling the pressure regulator.

3. A device according to Claim 2, wherein the controller is configured to control the regulator pilot valve.

4. A device according to Claim 3, comprising a pressure meter for measuring the pressure of the fluid, wherein the controller is configured to control the regulator pilot valve according to at least the pressure measured by the pressure meter.

5. A device according to any preceding claim, wherein the flow control valving means comprises a flow control valve and a stepper motor for controlling the flow control valve.

6. A device according to Claim 5, wherein the controller is configured to control the stepper motor.

7. A device according to any preceding claim, wherein the flow meter is arranged to measure the flow rate of fluid upstream from the flow control valving means.

8. A device according to any preceding claim, comprising means for inputting a desired fluid flow rate, wherein the controller is configured to control the flow control valving means according to at least the desired fluid flow rate and the measured flow rate.

9. A device according to Claim 8, comprising a display for displaying the input desired flow rate and the measured flow rate.

10. A device according to any preceding claim, comprising outflow valving means for applying suction via the outlet to draw fluid into the device through the outlet.

11. A device according to Claim 10, wherein the outflow valving means comprises a suck back valve and a pilot valve for pneumatically controlling the suck back valve.

12. A device according to any of Claims 1 to 9, comprising outflow valving means, wherein the controller is configured to control the outflow valving means such that the outflow valving means is changed from a fluid shut off position to a fluid flow position when the pressure regulating means and the flow control valving means are set for desired flow conditions.

13. A device according to any preceding claim, comprising an inflow port for receiving purge media and purge media valving means for controlling flow of purge media through at least a portion of the device comprising at least the outlet.

14. A device according to claim 13, wherein the purge media valving means comprises a purge media valve and a pilot valve for pneumatically controlling the purge media valve.

15. A device according to any preceding claim, comprising a check valve for limiting flow of fluid from the device via the inlet.

16. A device according to any preceding claim, comprising an inflow port for a pressurized substance, wherein the pressure regulating means is configured to be pneumatically controlled by using the pressurized substance.

17. A system for use in semiconductor processing, comprising at least one fluid flow control device according to any preceding claim, and at least one semiconductor processing tool for receiving fluid from the at least one fluid flow control device.

18. A system for use in controlling the flow of multiple fluids, comprising a first fluid flow control device, a second fluid flow control device, wherein each of the first fluid flow control device and the second fluid flow control device comprises a device according to any of Claims 1 to 16, and wherein the first and second fluid flow control devices are in communication with one another.

19. A system according to Claim 18, wherein the first fluid flow control device comprises a male connector and the second fluid flow control device comprises a female connector configured to be coupled to the male connector.

20. A system according to Claim 19, comprising a bus module configured to enable the system to be in communication with a controlling unit, wherein the bus module comprises a female connector configured to be coupled to a male connector of the second fluid flow control device.

21. A system for use in blending multiple fluids, comprising a first fluid flow control device, a second fluid flow control device, wherein each of the first fluid flow control device and the second fluid flow control device comprises a device according to any of Claims 1 to 16, and a mixer, wherein the outlet of each of the first and second flow devices is flow coupled to the mixer.

22. A system according to Claim 21, wherein the system is configured so as to control the first and second fluid flow control device so as to provide the mixer with multiple fluid flows, wherein each fluid flow has a controlled flow rate and a controlled flow rate duration.
